# EUROPEAN PATENT SPECIFICATION

(11) **EP 4 226 106 B1**
(45) Date of publication and mention of the grant of the patent: **07.01.2026**
(21) Application number: 20789945.1
(22) Date of filing: 09.10.2020
(51) Int. Cl.: F25D 29/00, H03K 17/96

(54) **HOUSEHOLD APPLIANCE WITH A USER INTERFACE**
APPAREIL MÉNAGER AVEC INTERFACE UTILISATEUR
HAUSHALTSGERÄT MIT BENUTZERSCHNITTSTELLE

(43) Date of publication of application: 16.08.2023
(73) Proprietor: ELECTROLUX APPLIANCES AKTIEBOLAG, 105 45 Stockholm (SE)
(72) Inventor: RIZZO, Luca, 33080 Porcia PN (IT); DAL CANTON, Tristano, 33080 Porcia PN (IT); BROCCA, Jose, 33080 Porcia PN (IT); KOBAYASHI, Luis, 105 45 Stockholm (SE)
(74) Representative: Electrolux Group Patents
(86) International application number: PCT/EP2020/078437
(87) International publication number: WO 2022/073620

(56) References cited:
- EP-A1- 2 662 981
- EP-A2- 2 385 630
- US-A1- 2019 121 461
- US-B1- 10 731 918

## Description

### Field of the invention

The present invention concerns the field of household appliances, especially refrigerating and/or freezing appliances. In particular, the present invention refers to household appliances with a user interface.

### Background art

Household appliances for cooling or freezing appliance can be built as separate devices or as combined devices, whereby in a refrigerating compartment goods such as vegetables, milk products etc. are cooled, and in a freezing compartment goods such as ice cream or frozen food can be stowed. Such an appliance comprises a cooling / freezing circuit with a cooling agent and a compressor, an evaporator and a condenser. The design of the cooling system is typically optimized to allow a cooling or freezing effect in the whole compartment and to a large degree independent on the concrete position of the goods to be cooled or frozen.

The user is typically given the possibility to interact with the appliance and set, for instance, the temperatures in the freezing and refrigerating compartments. For interaction of the user with the appliance, capacitive sensing elements can be used, which allow a comfortable operation of the appliance, since the proximity of a finger or a slight touch are sufficient to generate a control signal by the capacitive sensing element. These sensing elements can be associated with the overall operation of the machine and / or with a display and/or with a switch element. The sensing element can be associated with a specific display, especially a display which is arranged adjacent/proximal to the sensing element or a display which is built overlapping with the sensing element. In this way, the user immediately understands that interaction with the sensing element will have an influence on a quantity or symbol displayed in the adjacent display.

The capacitive sensing elements are typically manufactured of metal and tailor-made for the appliance and therefore lead to large production costs.

The EP 1 030 536 A2 discloses a touch switch for an electronic device with a sensing element with a sensing surface made of metal flat material which is associated with a corresponding display. Depending on the machine model, several displays with different dimensions and different values (i.e. two or more number) must to be used. It therefore can become difficult to create/manage several metal sheet sensing surfaces each tailored for each specific model.

US 10 731 918 B1 discloses an appliance with a control console, a circuit board and a capacitive touch sensor.

US 2019/121461 A1 discloses a capacitive touch sensor that includes a sensor pad on a printed circuit board.

EP 2 385 630 A2 discloses a capacitive touch switch.

### Summary of the invention

The aim of the invention is therefore to provide a household appliance with an improved design of the respective capacitive sensing element.

It is a further aim of the invention to increase the manufacturing efficiency and simultaneously decrease the manufacturing cost for an appliance.

It is a further aim to improve the processes of manufacturing management.

It is a further aim of the invention to reduce the necessary installation space and number of components.

### Description of the invention

The invention therefore relates household appliance with a user interface, comprising a display, a switch element associated to said display, comprising at least one capacitive sensing element with a sensing surface, a capacitive sensing circuit, a control unit connected to said display and to said capacitive sensing circuit, configured to control said household appliance and/or said display in function of (response to) a signal received from said capacitive sensing circuit after a user interaction on the capacitive sensing element of said switch element, whereby said capacitive sensing element is built as a PCB where the capacitive sensing circuit is provided.

The invention is defined in the independent claim.

Preferred embodiments of the invention are described in relation to the dependent claims and the description of the enclosed drawings.

The invention is based on the consideration that the capacitive sensing elements, which are usually built as metal pieces, involve a rather large production cost and are distinct and separate pieces which need to be manufactured. Especially when they need to have custom shapes, production costs rise.

Applicant has found that an improved design of a user interface can be realized by building the respective capacitive sensing element as a PCB (printed circuit board). While the production cost for these elements is reduced, at the same time this PCB can be used to hold the sensing circuit and thereby reduces the total amount of components needed. The respective PCB therefore assumes a two fold function by carrying the required circuit and at the same time serving as the input component for this circuit.

The term "associated" in claim 1 denotes that the commutation of the switch element causes a change of the information on the display.

The term "interaction" in claim 1 means that an action of a user causes a change of a signal from the switch element. Such an action, for instance is the placement of the user's finger in proximity of the area in front of the capacitive sensing element or a touch of the capacitive sensing element with the user's finger.

The display and the capacitive sensing element are respectively arranged on a display carrier element. The display carrier element serves as a carrier which can be mounted on a display main board or another component which is a base part of the electronics part of the user interface. In case of assembly / replacement needs of the display, the display carrier element can easily be assembled / replaced. The display carrier element in this way is a carrier element of a subassembly in which said sensing element is assembled. Therefore, a convenient assembly / replacement of the whole subassembly is also possible.

The display carrier element advantageously comprises at least one a recess, wherein at least one capacitive sensing element is placed in this recess. The capacitive sensing element is preferably placed in the recess to flush with the surface of the display. In this way, a comfortable user experience is realized since no edges between display and capacitive sensing element distract the finger motion or touch, especially when a common film is covering the respective display, the respective sensing element and at least partly the display carrier element.

The surface of said capacitive sensing element is preferably arranged flushing with the external surface of the display carrier element. In this way, a comfortable user experience is realized since no edges between display carrier element and capacitive sensing element distract the finger motion or touch, especially when a common film is covering the respective display, the respective sensing element and at least partly the display carrier element.

Preferably, the display and/or the switching element are mechanically connected to the display carrier element.

Preferably, the household appliance comprises a display main board to which the display and the switch element are connected. The main board can in this way serve as the carrier for the further components and can contain additional user interface elements.

In a preferred embodiment, the display main board comprises at least one additional switch element and/or at least one additional display element. The respective switch element preferably is a capacitive sensing element.

Advantageously, the household appliance comprises light elements for the display. The light elements are preferably associated with openings provided on the display carrier element, these openings being configured to see the light beams of the light elements from the front side of said user interface. This means that the light beams from the light elements can pass essentially or completely unhindered through these openings. In this way, the light elements can illuminate the display at dedicated regions.

Advantageously, the household appliance comprises a secondary board on which preferably the light elements for the display are assembled, which is electronically and/or mechanically connected to the display main board.

Advantageously, the household appliance comprises a secondary board on which light elements for the display are assembled and which is electronically and/or mechanically connected to the display main board. This configuration allows a convenient assembly of the user interface. In case some or all light elements are malfunctioning, only the secondary board needs to be replaced. The secondary board is preferably mechanically attached to the display main board by snap elements which engage in corresponding recesses on the display main board or vice versa. The electrical connection between the secondary board and the display is preferably realized by pins on the secondary board which engage with corresponding openings in the display main board.

The openings on the display carrier element preferably define one or more 7-digit displays visible from the front of the user interface.

Advantageously, the secondary board is at least partially covered by / at least partially arranged inside the display carrier element. In this way, the electronic components of the secondary elements are protected, and installation space is reduced.

The respective light elements are preferably built as LEDs, which is preferable due to the long lifetime of LEDs.

Preferably, the display comprises an LCD and/or touch display. In this way, an intuitive user interface can be realized.

The capacitive sensing element and at least partially the display advantageously are respectively at least partially covered by a at least partially transparent film which serves to provide a convenient user touch experience and protects the display and the capacitive sensing element.

Advantageously, the respective capacitive sensing element at least partially surrounds/encircles/encompasses a display region, which allows for the user to intuitively associate the sensing element with the display and to focus on this part of the user interface. Moreover, the total area for the user interface can be optimally utilized. The capacitive sensing element preferably has a C-shape, whereby in the inside of the C-shape at least partially the display is arranged.

The capacitive sensing element preferably comprises a recessed region encircling a display portion/display element of the display.

Preferably, the display is built as a 7-digit display.

Advantageously, two capacitive sensing elements are provided. These two sensing elements can be associated with two displays / two display portions and allow distinct operations of the appliance.

In a preferred embodiment, the household appliance is built as a refrigerating appliance or refrigerating/freezing appliance.

The advantages of the invention are especially as follows. The realization of the capacitive sensing element as a printed circuit board (PCB) saves production costs and allows installing circuitry of the user interface on the PCB, thereby saving the need for additional components.

### Brief description of the drawings

Further features and advantages of the present invention shall become clearer from the following detailed description of some of its preferred embodiments, made with reference to the attached schematic drawings and given as an indication and not for limiting purposes.

In particular, the attached drawings are included to provide a further understanding of the invention and are incorporated in and constitute a part of this specification. In the drawings, corresponding characteristics and/or components are identified by the same reference numbers. In these drawings:
- FIG. 1: shows a household appliance with a user interface in a perspective view;
- FIG. 2: shows the user interface in an exploded view;
- FIG. 3: shows components of the user interface in a exploded view; and
- FIG. 4: shows components of the user interface in an assembled state.

Same parts are labelled in all figures with identical reference numerals.

### Detailed Description of the Invention

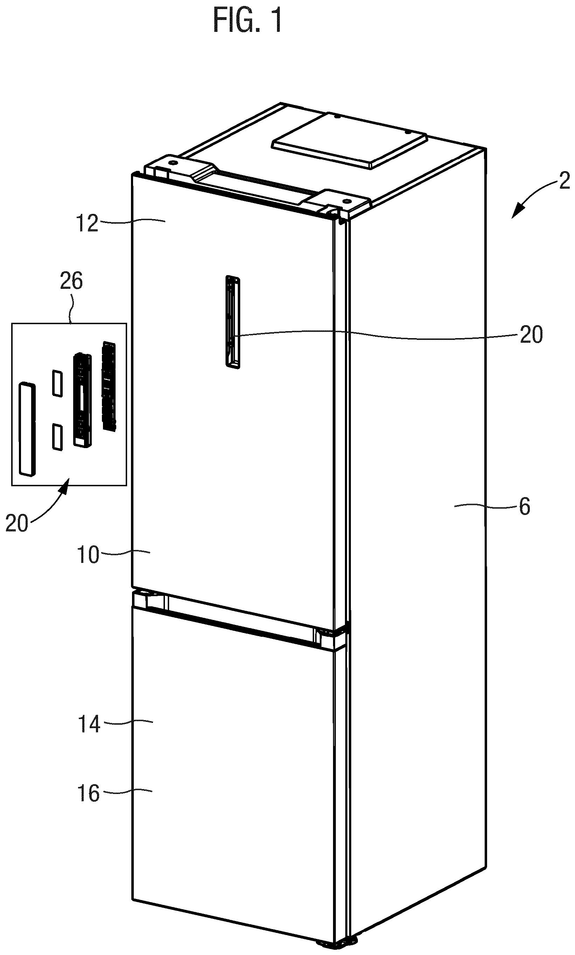

In FIG. 1, a household appliance 2 is shown which is built as a combined refrigerating and freezing appliance with a casing 6. Household appliance 2 shown comprises an upper front door 10 which gives access to a refrigerating compartment 12 as well as a lower front door 14 which gives access to a freezing compartment 16. Alternatively, the household appliance 2 could have one door only or several doors.

The household appliance 2 shown on the upper front door 10 comprises a user interface 20 for interacting with the household appliance 2 and for obtaining information which is displayed on the user interface 20. The user interface 20 is displayed in a box 26 in an exploded view. In other preferred embodiments, the user interface 20 can be arranged on the bottom door or lower front door 14 or on the cabinet (behind a door).

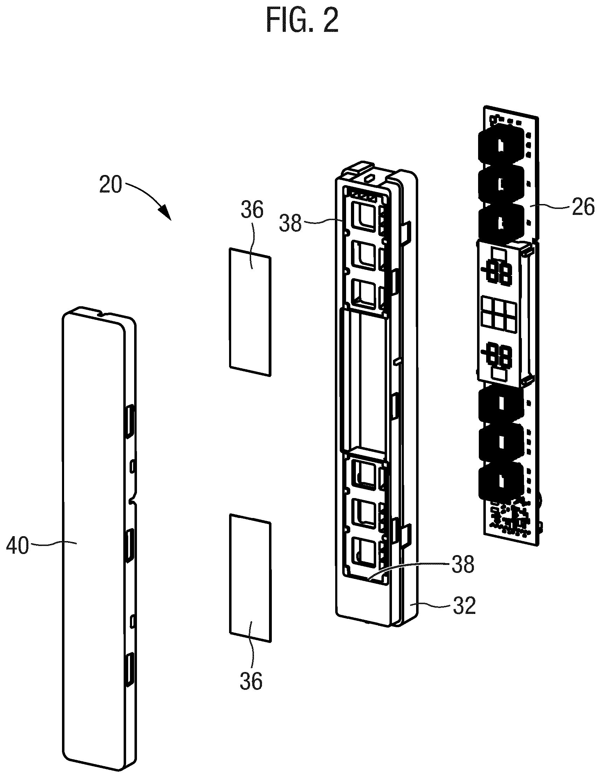

In FIG.2, the exploded view of box 26 of FIG. 1 is shown in greater detail. The user interface 20 preferably comprises an electronics part 26, a housing part 32, two inlays 36 and a cover part 40. The door 10 is preferably provided with a slot. The cover part 40 preferably comprises teeth. The electronics part 26 then is preferably assembled first with the housing part 32 and then with the cover part 40. Finally, the subassembly of components 26, 38, 36, 40 is preferably assembled on the slot provided in the door 10. Preferably, the teeth provided on the cover part 40 engage with suitable seats provided on this door slot.

The cover part 40 is preferably snapped to the housing part 32. The cover part 40 is advantageously built with a transparent and/or at least partially opaque material. As an example, it can be coloured in black with at least one portion allowing a light passage. In this way, cover part 40 fulfils simultaneously an aesthetic function as well as a protective function.

The aesthetic/transparent inlays 36 are positioned in corresponding recesses 38 provided on the housing part 32, sandwiched between said housing part 32 and said cover part 40 when the cover part 40 is assembled to housing part 32.

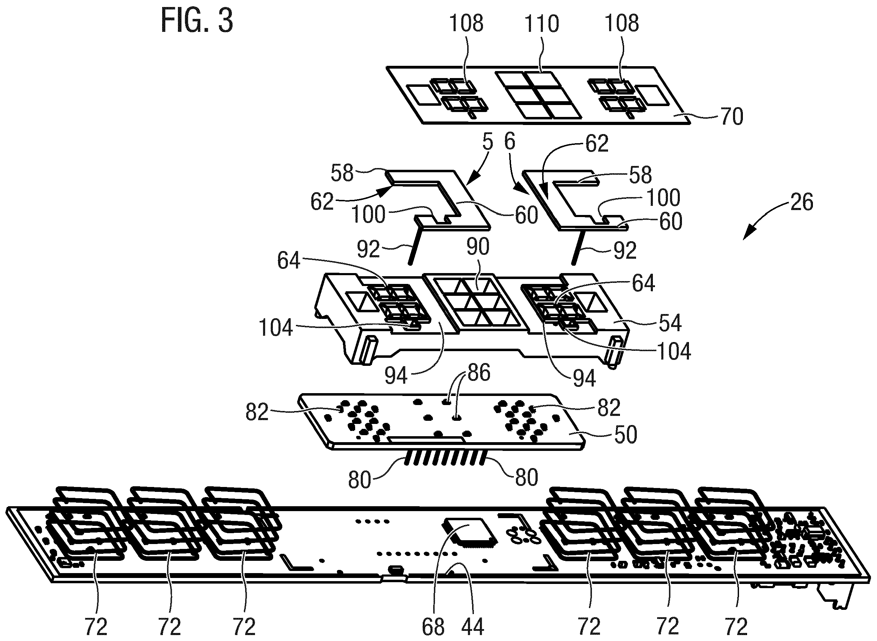

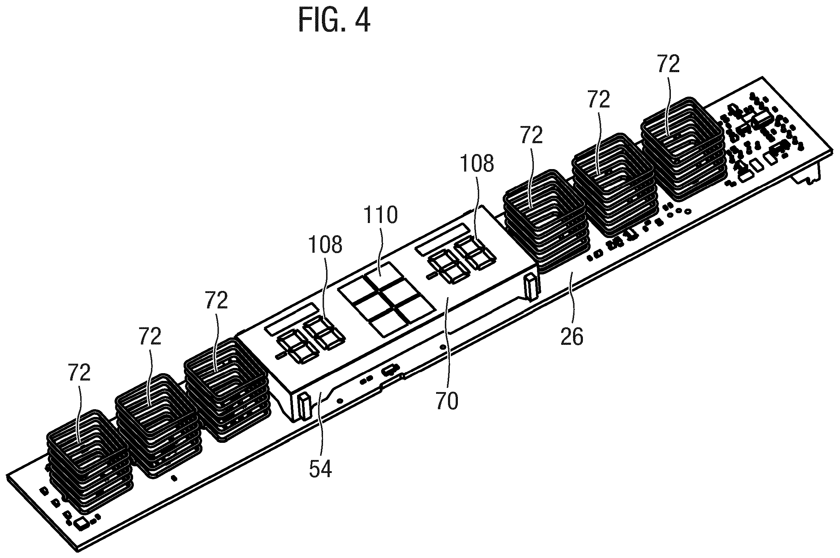

The electronics part 26 is shown in FIG. 3 in an exploded view and in FIG. 4 in an assembled state. In the mounted position, housing part 32 preferably encompasses electronics part 26 at the front and sides.

The electronics part 26 shown in FIG. 3 in an exploded view comprises (from bottom to top in FIG. 3) a display main board 44, a secondary board 50, a display carrier element 54, and a film 70. On the display carrier element 54, two switch elements comprising, respectively, a capacitive sensing element 58, are preferably arranged, which are, respectively, built as PCB 60. On the display carrier element 54 two displays 64 are preferably arranged. The displays 64 as well as the PCB 60 are preferably covered by the common at least partially transparent film 70. On the respective PCB 60, a capacitive sensing circuit 62 is arranged. The respective capacitive sensing element is connected to a control unit 68 which is preferably mounted on the display main board 44. Alternatively, the control unit can be the machine main control unit, opportunely connected to the capacitive sensing element.

The display main board 44 is essentially a carrier element of the other components and can be arranged in the appliance, while the other components shown in FIG. 3 are attached to it directly or via other components. The display main board 44 preferably comprises one or more, preferably six switching elements 72, each preferably comprising a spring, preferably a square spring, which are preferably used for functionalities that cannot be directly linked to the two displays 64. In a preferred embodiment, a first display 64 which comprises the sensing element 58 can display the fresh food compartment temperature. By touch operations on the sensing element 58, the user then can change the corresponding set temperature. The second display which also comprises a sensing element 58 can be used to display the freezer compartment temperature. By touch operations on the sensing element 58, the user then can change the corresponding set temperature. The other switches can, for instance, be used for these functionalities: ECO mode, air distribution regulation, extra cooling, extra freezing, connectivity, filter reset. In the mounted configuration, they are preferably arranged above and below the displays 64, see FIG. 1.

More preferably, each spring comprises on the center a light element, so that when the electronic part 26 is assembled with the housing part 32, each light element, when illuminated (i.e. in case of touch/proximity of the user's finger of the respective spring), provides a light beam that passes through a respective opening, preferably a square opening, on the housing part 32.

The secondary board 50 preferably comprises several electrically conducting pins 80 of which only two are labelled in the FIG. The pins electronically connect the secondary board 50 to the display main board 44. The secondary board 50 is preferably connected to the carrier element 54, the latter is preferably connected to the main board 44 through snap connections.

The secondary board 50 further preferably comprises two groups of light elements 82 which serve to illuminate display portions displays 64. Further light elements 86 (in the present embodiment six of them) are preferably arranged on secondary board 50 which are associated with openings 90 in the display carrier element 54. In the mounted configuration, the secondary board 50 is preferably received by the display carrier element 54.

The display carrier element 54 is preferably connected to the display main board 54 by a snap connection. Preferably the display carrier elements 54 in four corners comprises snap elements which engage with corresponding recesses in the display main board 44 or vice versa.

The display carrier element preferably comprises two recesses 94 which, respectively, each receiving a PCB 60. The depth of the respective recess 94 preferably corresponds to the depth of the respective PCB 60 such that in the fully assembled state the corresponding display surfaces flush with the surfaces of the PCB 60. In this way, the film 70 covers both displays 64 and PCB 60 in an even manner, leading to a high-grade look and user experience.

At least one pin 92 is preferably emerging from each of the capacitive sensing circuit 62 which is preferably supported by a hole on the carrier element 54 and is preferably electrically connected to the main board 44.

In the preferred embodiment shown, the respective PCB 60 preferably has a cross section resembling the shape of the capital letter "C". Each PCB 60 in this way encircles/encompasses the adjacent display 64. In this way, the PCB 60 can be arranged in direct adjacency to the display 64, signaling the user clearly which sensing element 58 is linked to which display. Each PCB 60 moreover preferably comprises a recess 100 in one of the wings of the "C"-shape which in the mounted state encompasses a respective display portion 104 that is preferably associated to a light element provided on the secondary board 50. As an example, the illumination of this light element can be controlled to blink until the set/displayed temperature is reached in the respective compartment.

The film 70, which is at least partly transparent, preferably comprises imprinted symbols 108 which are arranged on top of the respective display 84 and in the conjunction with the display 84 and the light elements 82 allow the display of numbers. The imprinted rectangles 110, which are preferably designed as squares, in conjunction with light elements 86, allow the indication of various system states.

### List of reference numerals

- 2: household appliance
- 6: casing
- 10: upper front door
- 12: refrigerating compartment
- 14: lower front door
- 16: freezing compartment
- 20: user interface
- 26: electronics part
- 32: housing part
- 36: inlay
- 38: recess
- 40: cover part
- 44: display main board
- 50: secondary board
- 54: display carrier element
- 56: switch element
- 58: capacitive sensing element
- 60: PCB
- 62: capacitive sensing circuit
- 64: display
- 68: control unit
- 70: film
- 72: switching element
- 80: pin
- 82: light element
- 86: light element
- 90: opening
- 92: pin
- 94: recess
- 100: recess
- 104: display portion
- 108: imprinted symbols
- 110: imprinted rectangles

## Claims

1. Household appliance (2) with a user interface (20), comprising:
- a display (64),
- a switch element (56) associated to said display (64), comprising at least one capacitive sensing element (58) with a sensing surface,
- a capacitive sensing circuit (62),
- a control unit (68) connected to said display (64) and to said capacitive sensing circuit (62), configured to control said household appliance (2) and/or said display (64) in function of a signal received from said capacitive sensing circuit (62) after a user interaction on the capacitive sensing element (58) of said switch element (56), **characterized in that**
said capacitive sensing element (58) is built as a PCB (60) where the capacitive sensing circuit (62) is provided, whereby said display (64) and said capacitive sensing element (58) are respectively arranged on a display carrier element (54).

2. Household appliance (2) according to claim 1, whereby said display carrier element (54) comprises at least one a recess (94), wherein at least one capacitive sensing element (58) is placed in said recess (94).

3. Household appliance (2) according to claim 2, whereby the surface of said capacitive sensing element (58) is arranged flushing with the external surface of said display carrier element (54).

4. Household appliance (2) according to one of the claims 1 to 3, whereby said display (64) and/or said switching element (56) are mechanically connected to said display carrier element (54).

5. Household appliance (2) according to one of the previous claims, comprising a display main board (44) to which said display (64) and said switch element (56) are connected.

6. Household appliance (2) according to claim 5, whereby said display main board (44) comprises at least one additional switch element (72) and/or at least one additional display element.

7. Household appliance (2) according to one of the previous claims, comprising light elements (82) for said display (64).

8. Household appliance (2) according to claim 7 when depending on claims 1 to 4, whereby said light elements (82) are associated with openings provided on said display carrier element (54), said openings being configured to see the light beams of said light elements (82) from the front side of said user interface (20).

9. Household appliance (2) according to claim 8, whereby said openings on said display carrier element (54) define one or more 7-digit displays (64) visible from the front of said user interface (20).

10. Household appliance (2) according to one of claims 1 to 9, comprising a secondary board (50), whereby said secondary board (50) is at least partially covered by / at least partially arranged inside said display carrier element (54).

11. Household appliance (2) according to one of the claims 7 to 10, whereby said respective light elements (82) are built as LEDs.

12. Household appliance (2) according to one of the claims 1 to 11, whereby said display (64) comprises an LCD and/or touch display.

13. Household appliance (2) according to one of the claims 1 to 12, whereby said capacitive sensing element (58) and at least partially said display (64) are respectively at least partially covered by an at least partially transparent film (70).

14. Household appliance (2) according to one of the claims 1 to 13, whereby said respective capacitive sensing element (58) at least partially surrounds a display region.

15. Household appliance (2) according to one of the claims 1 to 13, whereby said capacitive sensing element (58) comprises a recessed region (100) encircling a portion (104) of said display (64).

16. Household appliance (2) according to one of the claims 1 to 15, whereby said display (64) is built as a 7-digit display.

17. Household appliance (2) according to one of the previous claims, whereby at least two capacitive sensing elements (58) are provided.

18. Household appliance (2) according to one of the previous claims which is built as a refrigerating appliance or refrigerating/freezing appliance.

## Patentansprüche

1. Haushaltsgerät (2) mit einer Benutzerschnittstelle (20), umfassend:
- eine Anzeige (64),
- ein mit der Anzeige (64) assoziiertes Schaltelement (56), das mindestens ein kapazitives Sensorelement (58) mit einer Sensorfläche umfasst,
- eine kapazitive Sensorschaltung (62),
- eine Steuereinheit (68), die mit der Anzeige (64) und der kapazitiven Sensorschaltung (62) verbunden ist und so konfiguriert ist, dass sie das Haushaltsgerät (2) und/oder die Anzeige (64) in Abhängigkeit von einem Signal steuert, das von der kapazitiven Sensorschaltung (62) nach einer Benutzerinteraktion mit dem kapazitiven Sensorelement (58) des Schaltelements (56) empfangen wird, **dadurch gekennzeichnet, dass**
das kapazitive Sensorelement (58) als Leiterplatte (60) ausgebildet ist, auf der die kapazitive Sensorschaltung (62) bereitgestellt ist, wobei die Anzeige (64) und das kapazitive Sensorelement (58) jeweils auf einem Anzeigeträgerelement (54) angeordnet sind.

2. Haushaltsgerät (2) nach Anspruch 1, wobei das Anzeigeträgerelement (54) mindestens eine Aussparung (94) umfasst, wobei sich mindestens ein kapazitives Sensorelement (58) in der Aussparung (94) befindet.

3. Haushaltsgerät (2) nach Anspruch 2, wobei die Oberfläche des kapazitiven Sensorelements (58) bündig mit der Außenfläche des Anzeigeträgerelements (54) angeordnet ist.

4. Haushaltsgerät (2) nach einem der Ansprüche 1 bis 3, wobei die Anzeige (64) und/oder das Schaltelement (56) mechanisch mit dem Anzeigeträgerelement (54) verbunden sind.

5. Haushaltsgerät (2) nach einem der vorhergehenden Ansprüche, umfassend eine Anzeigehauptplatine (44), mit der die Anzeige (64) und das Schaltelement (56) verbunden sind.

6. Haushaltsgerät (2) nach Anspruch 5, wobei die Anzeigehauptplatine (44) mindestens ein zusätzliches Schaltelement (72) und/oder mindestens ein zusätzliches Anzeigeelement umfasst.

7. Haushaltsgerät (2) nach einem der vorhergehenden Ansprüche, umfassend Leuchtelemente (82) für die Anzeige (64) .

8. Haushaltsgerät (2) nach Anspruch 7, soweit dieser von den Ansprüchen 1 bis 4 abhängt, wobei die Leuchtelemente (82) mit Öffnungen assoziiert sind, die an dem Anzeigeträgerelement (54) bereitgestellt sind, wobei die Öffnungen so konfiguriert sind, dass die Lichtstrahlen der Leuchtelemente (82) von der Vorderseite der Benutzerschnittstelle (20) aus sichtbar sind.

9. Haushaltsgerät (2) gemäß Anspruch 8, wobei die Öffnungen auf dem Anzeigeträgerelement (54) eine oder mehrere 7-stellige Anzeigen (64) definieren, die von der Vorderseite der Benutzerschnittstelle (20) aus sichtbar sind.

10. Haushaltsgerät (2) nach einem der Ansprüche 1 bis 9, umfassend eine Sekundärplatine (50), wobei die Sekundärplatine (50) zumindest teilweise von dem Anzeigeträgerelement (54) abgedeckt ist bzw. zumindest teilweise innerhalb desselben angeordnet ist.

11. Haushaltsgerät (2) nach einem der Ansprüche 7 bis 10, wobei die jeweiligen Leuchtelemente (82) als LEDs ausgebildet sind.

12. Haushaltsgerät (2) nach einem der Ansprüche 1 bis 11, wobei die Anzeige (64) eine LCD- und/oder Berührungsanzeige umfasst.

13. Haushaltsgerät (2) nach einem der Ansprüche 1 bis 12, wobei das kapazitive Sensorelement (58) und zumindest teilweise die Anzeige (64) jeweils zumindest teilweise von einer zumindest teilweise transparenten Folie (70) bedeckt sind.

14. Haushaltsgerät (2) nach einem der Ansprüche 1 bis 13, wobei das jeweilige kapazitive Sensorelement (58) zumindest teilweise einen Anzeigebereich umgibt.

15. Haushaltsgerät (2) nach einem der Ansprüche 1 bis 13, wobei das kapazitive Sensorelement (58) einen ausgesparten Bereich (100) umfasst, der einen Abschnitt (104) der Anzeige (64) umgibt.

16. Haushaltsgerät (2) nach einem der Ansprüche 1 bis 15, wobei die Anzeige (64) als 7-stellige Anzeige ausgebildet ist.

17. Haushaltsgerät (2) nach einem der vorhergehenden Ansprüche, wobei mindestens zwei kapazitive Sensorelemente (58) bereitgestellt sind.

18. Haushaltsgerät (2) nach einem der vorhergehenden Ansprüche, das als Kühlgerät oder Kühl-/Gefriergerät ausgebildet ist.

## Revendications

1. Appareil ménager (2) doté d'une interface utilisateur (20), comprenant :
- un affichage (64),
- un élément de commutation (56) associé audit affichage (64), comprenant au moins un élément de détection capacitif (58) ayant une surface de détection,
- un circuit de détection capacitif (62),
- une unité de commande (68) connectée audit affichage (64) et audit circuit de détection capacitif (62), configurée pour commander ledit appareil ménager (2) et/ou ledit affichage (64) en fonction d'un signal reçu depuis ledit circuit de détection capacitif (62) après une interaction d'utilisateur sur l'élément de détection capacitif (58) dudit élément de commutation (56),
**caractérisé en ce que**
ledit élément de détection capacitif (58) est réalisé sous la forme d'une carte de circuit imprimé (60) dans laquelle est placé le circuit de détection capacitif (62), ledit affichage (64) et ledit élément de détection capacitif (58) étant respectivement disposés sur un élément de support d'affichage (54).

2. Appareil ménager (2) selon la revendication 1, dans lequel ledit élément de support d'affichage (54) comprend au moins un évidement (94), dans lequel au moins un élément de détection capacitif (58) est placé dans ledit évidement (94).

3. Appareil ménager (2) selon la revendication 2, dans lequel la surface dudit élément de détection capacitif (58) est agencée de manière à affleurer la surface externe dudit élément de support d'affichage (54).

4. Appareil ménager (2) selon l'une des revendications 1 à 3, dans lequel ledit affichage (64) et/ou ledit élément de commutation (56) sont reliés mécaniquement audit élément de support d'affichage (54).

5. Appareil ménager (2) selon l'une quelconque des revendications précédentes, comprenant une carte principale d'affichage (44) à laquelle ledit affichage (64) et ledit élément de commutation (56) sont connectés.

6. Appareil ménager (2) selon la revendication 5, dans lequel ladite carte principale d'affichage (44) comprend au moins un élément de commutation supplémentaire (72) et/ou au moins un élément d'affichage supplémentaire.

7. Appareil ménager (2) selon l'une quelconque des revendications précédentes, comprenant des éléments lumineux (82) pour ledit affichage (64).

8. Appareil ménager (2) selon la revendication 7 lorsqu'elle dépend des revendications 1 à 4, dans lequel lesdits éléments lumineux (82) sont associés à des ouvertures placées sur ledit élément de support d'affichage (54), lesdites ouvertures étant conçues pour voir les faisceaux lumineux desdits éléments lumineux (82) depuis le côté avant de ladite interface utilisateur (20).

9. Appareil ménager (2) selon la revendication 8, dans lequel lesdites ouvertures sur ledit élément de support d'affichage (54) définissent un ou plusieurs affichages à 7 chiffres (64) visibles depuis l'avant de ladite interface utilisateur (20).

10. Appareil ménager (2) selon l'une des revendications 1 à 9, comprenant une carte secondaire (50), dans lequel ladite carte secondaire (50) est au moins partiellement recouverte par/au moins partiellement disposée à l'intérieur dudit élément de support d'affichage (54).

11. Appareil ménager (2) selon l'une des revendications 7 à 10, dans lequel lesdits éléments lumineux respectifs (82) sont réalisés sous la forme de diodes électroluminescentes.

12. Appareil ménager (2) selon l'une des revendications 1 à 11, dans lequel ledit affichage (64) comprend un affichage LCD et/ou tactile.

13. Appareil ménager (2) selon l'une des revendications 1 à 12, dans lequel ledit élément de détection capacitif (58) et au moins partiellement ledit affichage (64) sont respectivement au moins partiellement recouverts d'un film au moins partiellement transparent (70).

14. Appareil ménager (2) selon l'une des revendications 1 à 13, dans lequel ledit élément de détection capacitif respectif (58) entoure au moins partiellement une région d'affichage.

15. Appareil ménager (2) selon l'une des revendications 1 à 13, dans lequel ledit élément de détection capacitif (58) comprend une région évidée (100) entourant une partie (104) dudit affichage (64).

16. Appareil ménager (2) selon l'une des revendications 1 à 15, dans lequel ledit affichage (64) est réalisé sous la forme d'un affichage à 7 chiffres.

17. Appareil ménager (2) selon l'une des revendications précédentes, dans lequel au moins deux éléments de détection capacitifs (58) sont prévus.

18. Appareil ménager (2) selon l'une des revendications précédentes, qui est réalisé sous la forme d'un appareil de réfrigération ou d'un appareil de réfrigération/congélation.
